# DEMANDE DE BREVET EUROPEEN

(11) **EP 3 660 921 A1**
(43) Date de publication de la demande: **03.06.2020**
(21) Numéro de dépôt: 19212784.3
(22) Date de dépôt: 02.12.2019
(51) Int. Cl.: H01L 29/12, H01L 29/423, H01L 29/66, H01L 29/76, B82Y 10/00, B82Y 40/00

(54) **PROCÉDÉ DE FABRICATION D'UN COMPOSANT ÉLECTRONIQUE À MULTIPLES ÎLOTS QUANTIQUES ET COMPOSANT ÉLECTRONIQUE RÉSULTANT**

(30) Priorité: 02.12.2018 FR 1872199
(71) Demandeur: Commissariat à l'énergie atomique et aux énergies alternatives, 75015 Paris (FR)
(72) Inventeur: POSSEME, Nicolas, 38054 Grenoble Cedex 09 (FR); HUTIN, Louis, 38054 Grenoble Cedex 09 (FR); LE ROYER, Cyrille, 38054 Grenoble Cedex 09 (FR); NEMOUCHI, Fabrice, 38054 Grenoble Cedex 09 (FR)
(74) Mandataire: Guérin, Jean-Philippe

(57) **Abrégé**

L'invention concerne un procédé de fabrication d'un composant électronique (1) à multiples îlots quantiques, comprenant les étapes de :
-fourniture d'un empilement incluant un substrat (100), une nano structure (110) en matériau semi-conducteur superposé sur le substrat (100), comportant des premier et deuxième îlots quantiques (111, 112) et une liaison (115) reliant ces premier et deuxième îlots quantiques, des premier et deuxième empilements de grille de commande (143, 144) disposés sur lesdits premier et deuxième îlots quantiques (111, 112), lesdits empilements de grille (143, 144) étant séparés par une gorge (15), les îlots quantiques et ladite liaison (115) présentant une même épaisseur;
-amincissement partiel de ladite liaison (115) en utilisant les empilements de grille (143, 144) comme masques, de façon à obtenir une liaison présentant une épaisseur inférieure à celle des îlots quantiques ;
-formation d'une couche de diélectrique (119) sur ladite liaison amincie (115).

## Description

L'invention concerne le domaine de la spintronique, et notamment les composants électroniques à multiples boîtes, îlots ou bits quantiques couplés entre eux, ainsi que leurs procédés de fabrication.

L'électronique quantique fournit une base pour des améliorations de performances. Par analogie avec l'électronique classique, le bit quantique représente l'élément de base du calcul pour l'électronique quantique. En électronique classique, des calculs booléens sont réalisés à partir de bits présentant un état parmi deux possibles. Un bit quantique est une superposition des états propres |0> et |1>.

Les îlots quantiques servent d'éléments de base à l'électronique quantique. Les îlots quantiques utilisent des nanostructures de semi-conducteurs pour former des puits de potentiel pour confiner des électrons ou des trous dans les trois dimensions de l'espace. L'information quantique est alors codée dans des degrés de liberté purement quantiques : en l'occurrence le spin ½ de l'électron. Les boîtes quantiques visent à isoler un ou plusieurs porteurs de charge pour définir un qubit à partir de leur spin. En tirant parti des phénomènes quantiques de superposition et d'intrication, certains algorithmes permettent alors de bénéficier d'une amélioration polynomiale voire exponentielle du temps de calcul par rapport à leurs homologues basés sur la logique binaire. Selon une approche, des électrons sont confinés par effet de champ sous des grilles de transistors, et l'information est encodée dans le spin de ces électrons.

Pour réaliser des opérations logiques quantiques, il est important de pouvoir :
- manipuler l'état quantique des qubits ;
- détecter un changement des états quantiques des qubits ;
- faire communiquer les qubits entre eux via un couplage quantique ajustable ou modulable.

Pour faire communiquer des qubits adjacents avec un mécanisme de couplage ajustable, il est connu d'ajuster la barrière de potentiel Coulombien entre ces qubits adjacents.

Selon certaines conceptions, le contrôle d'un qubit est assuré par une grille primaire positionnée à la verticale du qubit, la modulation de la barrière de potentiel étant assurée par une grille secondaire positionnée à la verticale de l'espace entre deux qubits adjacents.

Afin d'assurer un couplage entre des qubits adjacents, il peut s'avérer important que ces qubits soient très proches, ce qui peut imposer un pas inférieur à 100nm entre les grilles primaires de ces qubits.

Par ailleurs, le couplage entre deux qubits adjacents s'avère optimal avec une résistance tunnel accrue entre les deux qubits. Les qubits adjacents sont généralement réalisés dans un même nanofil de Silicium, le nanofil de silicium s'étendant par ailleurs entre les qubits pour former une résistance tunnel. Le nanofil s'étend également d'un premier qubit vers un premier réservoir de porteurs, et d'un autre qubit vers un deuxième réservoir de porteurs. L'augmentation de la résistance tunnel s'avère industriellement difficile à obtenir, à partir de l'épaisseur de nanofil utilisée pour les qubits.

L'invention vise à résoudre un ou plusieurs de ces inconvénients. L'invention porte ainsi sur un procédé de fabrication d'un composant électronique à multiples îlots quantiques, tel que défini dans les revendications annexées. L'invention porte également sur un composant électronique à multiples îlots quantiques tel que défini dans les revendications annexées.

L'homme du métier comprendra que chacune des caractéristiques d'une revendication dépendante ou de la description peut être combinée indépendamment aux caractéristiques d'une revendication indépendante, sans pour autant constituer une généralisation intermédiaire.

D'autres caractéristiques et avantages de l'invention ressortiront clairement de la description qui en est faite ci-après, à titre indicatif et nullement limitatif, en référence aux dessins annexés, dans lesquels :

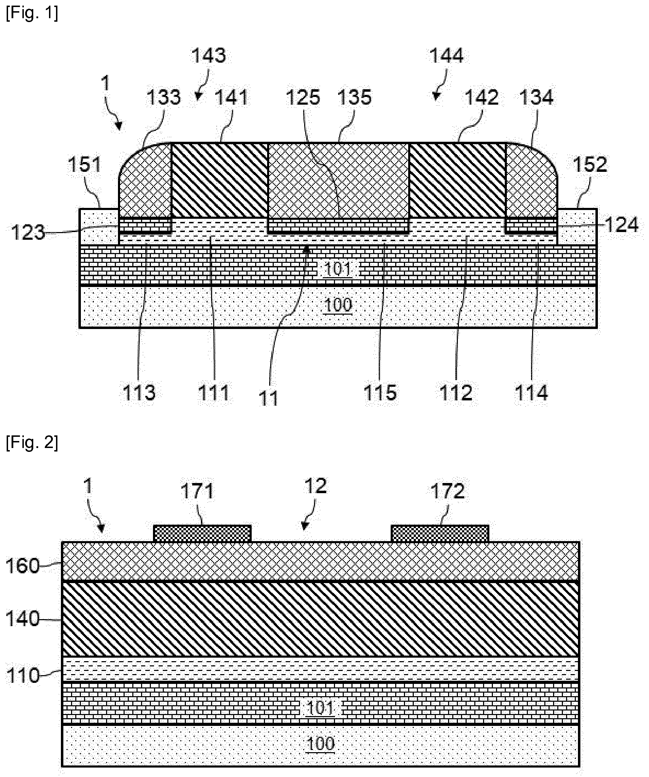

[Fig.1] est une vue en coupe schématique d'un exemple de circuit à îlots quantiques obtenu par un procédé de fabrication selon l'invention ;
[Fig. 2],
[Fig. 3],
[Fig. 4],
[Fig. 5],
[Fig. 6] et
[Fig. 7] sont des vues en coupe schématique d'un circuit à îlots quantiques de la figure 1 à différentes étapes d'un procédé de fabrication selon un exemple d'un premier mode de réalisation ;
[Fig. 8] est un diagramme récapitulant les étapes mises en œuvre dans ce procédé de fabrication ;
[Fig. 9],
[Fig. 10],
[Fig. 11]

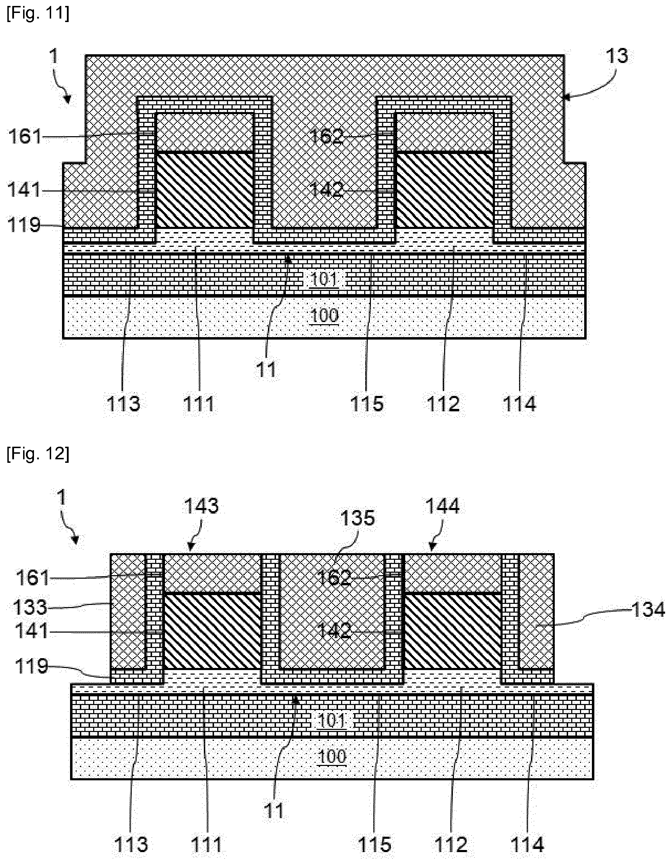

[Fig. 12] et

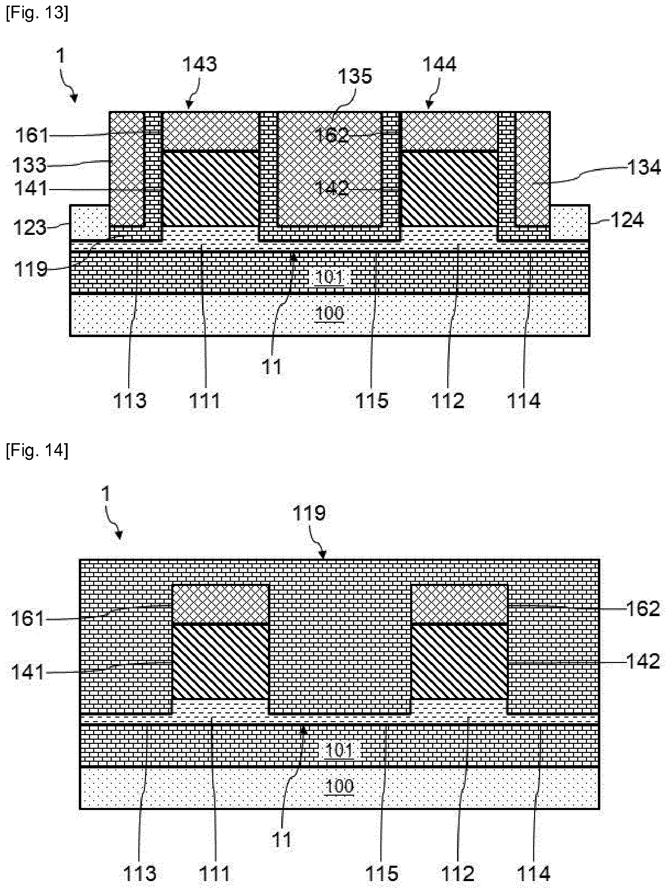

[Fig. 13], sont des vues en coupe schématique d'un circuit à îlots quantiques de la figure 1 à différentes étapes d'un procédé de fabrication selon un exemple d'un deuxième mode de réalisation ;
[Fig. 14] et

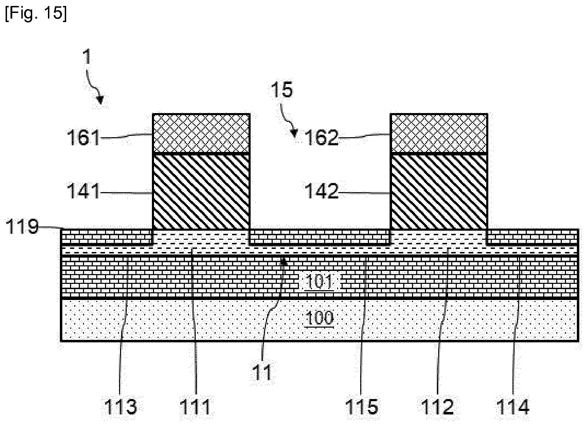

[Fig. 15] sont des vues en coupe schématique d'un circuit à îlots quantiques de la figure 1 à différentes étapes d'un procédé de fabrication selon un exemple d'un troisième mode de réalisation.

La figure 1 est une vue en coupe d'un exemple de circuit 1 à îlots quantiques multiples obtenu selon un procédé de fabrication selon l'invention. Le circuit 1 comporte un substrat 100 en matériau semi-conducteur. Le substrat 100 est ici recouvert d'une couche de diélectrique enterrée 101. Une nano structure 11 en matériau semi-conducteur est disposée sur la couche de diélectrique 101. La nano structure 11 se présente ici sous forme de nanofil. Le matériau semi-conducteur de la nano structure 11 est par exemple un semi-conducteur non intentionnellement dopé. Le matériau de la nano structure 11 est par exemple du silicium.

La nano structure 11 comprend des îlots quantiques 111 et 112. Les îlots quantiques 111 et 112 forment des régions de confinement des qubits. Les îlots quantiques 111 et 112 peuvent par exemple présenter une largeur comprise entre 5 et 40 nanomètres. Les îlots quantiques 111 et 112 peuvent par exemple présenter une épaisseur comprise entre 5 et 20 nanomètres. Les îlots quantiques 111 et 112 sont couplés. La nano structure 11 comprend ainsi une liaison 115 reliant les îlots quantiques 111 et 112. La liaison 115 couple les îlots quantiques 111 et 112 par effet tunnel. Les îlots quantiques 111 et 112 peuvent typiquement être séparés d'une distance comprise entre 20 et 120 nanomètres. Une telle distance correspond typiquement à des îlots quantiques à effet électrostatique. Afin de présenter une résistance électrique relativement élevée, la liaison 115 peut avantageusement comporter une épaisseur comprise entre 2 et 10 nm, typiquement de 3 nm.

Le circuit comprend avantageusement des réservoirs de porteurs 151 et 152 disposés de part et d'autre de la nano structure 11. Les réservoirs de porteurs 151 et 152 sont ici en matériau semi-conducteur. Les réservoirs de porteurs 151 et 152 sont en contact électrique avec des extrémités respectives de la nano structure 11 (ici par des faces verticales des extrémités de la nanostructure 11. Selon une variante, les réservoirs de porteurs 151 et 152 peuvent être positionnés au-dessus des première et deuxième extrémités de la nanostructure 11). La nano structure 11 comporte une liaison 113, par l'intermédiaire de laquelle le réservoir de porteurs 151 est en contact par effet tunnel avec l'îlot quantique 111. La nano structure 11 comporte une liaison 114, par l'intermédiaire de laquelle le réservoir de porteurs 152 est en contact par effet tunnel avec l'îlot quantique 112. Les liaisons 113 et 114 présentent avantageusement une épaisseur comprise entre 2 et 10 nm, typiquement de 3 nm.

Un empilement de grille de commande 143 est disposé sur l'îlot quantique 111. L'empilement de grille de commande 143 inclut ici une grille de commande 141 et un isolant de grille non illustré. La grille de commande 141 est par exemple réalisée en polysilicium dopé. L'empilement de grille de commande 143 est aligné avec la verticale de l'îlot quantique 111. Un empilement de grille de commande 144 est disposé sur l'îlot quantique 112. L'empilement de grille de commande 144 inclut ici une grille de commande 142 et un isolant de grille non illustré. La grille de commande 142 est par exemple réalisée en polysilicium dopé. L'empilement de grille de commande 144 est aligné avec la verticale de l'îlot quantique 112.

La liaison 115 est recouverte par une couche de diélectrique 125. La couche de diélectrique 125 est par exemple formée en SiO₂. La couche de diélectrique 125 est recouverte par un espaceur 135. L'espaceur 135 est par exemple formé en SiN. L'espaceur 135 remplit la gorge entre les empilements 143 et 144. L'espaceur 135 s'étend entre les empilements de grille 143 et 144. Les liaisons 113 et 114 sont recouvertes respectivement par des couches de diélectrique 123 et 124. Les couches de diélectrique 123 et 124 sont par exemple formées en SiO₂. Les couches de diélectrique 123 et 124 sont recouvertes respectivement par des espaceurs 133 et 134. Une couche de diélectrique est ainsi disposée de part et d'autre des empilements de grille 143 et 144 et remplit la gorge entre ces empilements. L'espaceur 135 est ici obtenu par dépôt conforme de matériau diélectrique.

La couche de diélectrique 101 peut par exemple présenter une épaisseur comprise entre 10 et 50 nanomètres. Par une polarisation appropriée du substrat 100, on peut ajuster le couplage entre les îlots quantiques 111 et 112. Le substrat 100 peut alors être utilisé comme grille arrière. On peut ainsi moduler la barrière de potentiel coulombien située entre ces deux îlots quantiques 111 et 112. La grille arrière permet notamment de régler le degré de couplage entre les deux îlots quantiques 111 et 112 adjacents par ajustement de la barrière tunnel qui les sépare. Suivant la polarité appliquée sur la grille arrière formée, la barrière tunnel peut être réduite (couplage fort) ou augmentée (couplage faible, confinement élevé), avec un couplage minimal vis-à-vis des autres jonctions tunnel ou des grilles de commande des îlots quantiques 111 et 112.

Le substrat 100 peut localement être dopé, avec un dopage avantageusement au moins égal à 10¹⁹ cm⁻³, pour former une grille arrière. Le dopage du substrat 100 peut par exemple être réalisé par implantation ionique, par exemple avant une étape de dépôt d'une couche formant la nano structure 110 sur la couche d'isolant 101.

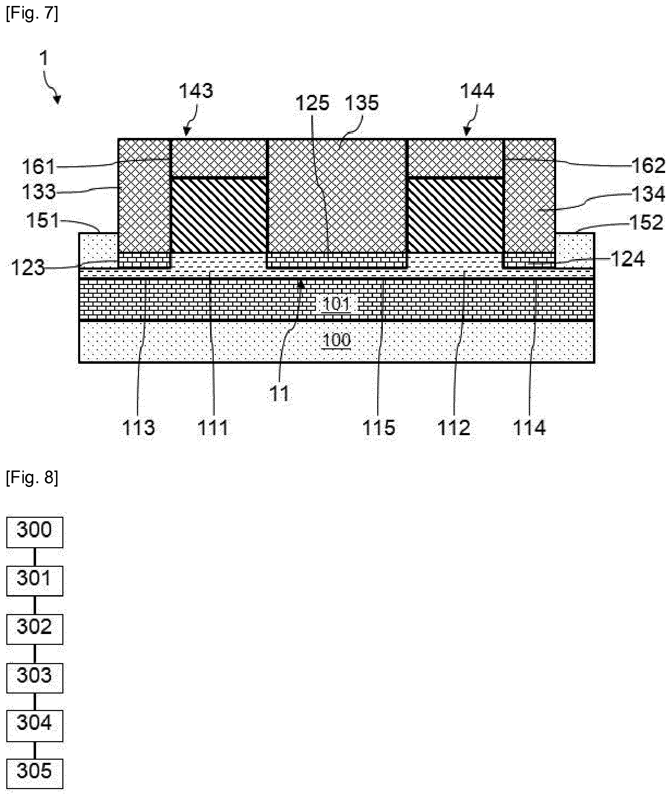

Les figures 2 à 7 illustrent des vues en coupe et de dessus d'un composant 1 à îlots quantiques multiples à différentes étapes d'un exemple d'un premier mode de réalisation d'un procédé de fabrication selon l'invention. La figure 8 est un diagramme récapitulant les étapes mises en œuvre dans ce procédé. Le descriptif des étapes 300 et 301 est fourni à titre illustratif mais ces étapes sont connues en soi de l'homme du métier et peuvent être réalisées différemment.

Dans ce cas particulier, la présence d'une couche 119 de SiO₂ sur la liaison 115 permet d'avoir une très bonne qualité d'interface au niveau de la liaison 115, et ainsi de réduire le bruit et/ou les parasites pour les qubits des îlots quantiques 111 et 112.

A la figure 2, l'étape 300 est mise en œuvre. On fournit ici au préalable un substrat de type semi-conducteur sur isolant. Une nano structure 110 (par exemple du silicium non intentionnellement dopé) est ainsi disposée sur une couche de diélectrique 101, typiquement en SiO₂. La couche de diélectrique 101 est ici formée sur un substrat semi-conducteur 100, typiquement en Silicium non intentionnellement dopé. La nano structure 110 est ici recouverte d'une couche de matériau de grille 140. La couche de matériau de grille 140 est par exemple du polysilicium. Une couche de diélectrique de grille non illustrée est avantageusement interposée entre la couche 140 et la nano structure 110. La couche de matériau de grille 140 est ici recouverte d'une couche de masque dur 160. La couche de masque dur 160 est par exemple en SiN ou en SiO₂. Des masques de résine durcie 171 et 172 sont positionnés sur la couche de masque dur 160. Les masques 171 et 172 sont séparés par une rainure 12. Les masques 171 et 172 sont typiquement réalisés par photolithographie.

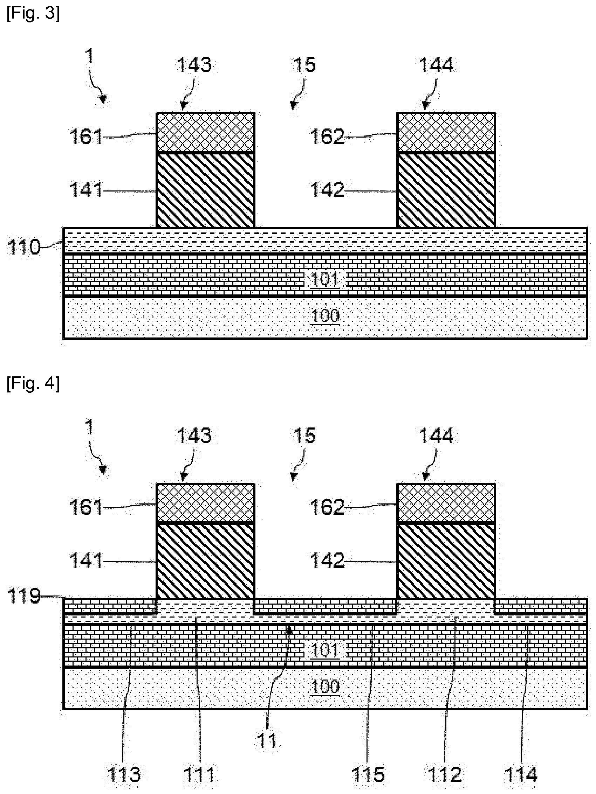

À la figure 3, l'étape 301 est mise en œuvre. On procède ici à une gravure anisotrope des parties non recouvertes par les motifs des masques 171 et 172. La couche 160 est notamment gravée de part et d'autre des masques 171 et 172. La gravure de la couche 160 est par exemple mise en œuvre par plasma en chimie fluorocarbonée, dans un réacteur plasma à couplage inductif (ICP). La gravure se poursuit par la gravure de la couche 140 de part et d'autre des masques 171 et 172. La gravure de la couche 140 est par exemple mise en œuvre dans un réacteur plasma ICP, en chimie fluorocarbonée ou HBr, en plasma continu ou pulsé. La gravure de la couche 140 est mise en œuvre avec arrêt sur la nano structure 110. Les masques 171 et 172 sont ensuite retirés. On obtient ainsi des empilements de grille 143 et 144, incluant respectivement une grille de commande 141 surmontée d'un masque dur 161, et une grille de commande 142 surmontée d'un masque dur 162. La gravure de la rainure 12 entre les masques 171 et 172 aboutit à la formation d'une gorge 15 entre les empilements de grille 143 et 144. La nano structure 110 est alors découverte de part et d'autre des empilements de grille 143 et 144, et notamment au fond de la gorge 15 ménagée entre ces empilements de grille 143 et 144.

À la figure 4, l'étape 302 est mise en œuvre selon un procédé selon un premier mode de réalisation. On met ici en œuvre une étape d'amincissement partiel de la liaison 115. L'amincissement partiel de la liaison 115 est mis en œuvre en utilisant les empilements de grille 143 et 144 comme masques. Ainsi, la partie amincie de la liaison 115 est auto-alignée avec les faces latérales des empilements de grille 143 et 144, afin de garantir un bon contrôle dimensionnel de la liaison 115. On peut ainsi garantir une valeur précise de la résistance tunnel de la liaison 115. Avantageusement, les liaisons 113 et 114 sont également partiellement amincies. L'amincissement partiel des liaisons 113 à 115 de la nano structure 110 est ici mise en œuvre par oxydation des parties découvertes de cette nano structure 110. L'amincissement partiel de la nano structure 110 est mis en œuvre de sorte que les liaisons 113 à 115 sont moins épaisses que les îlots quantiques 111 et 112. L'amincissement partiel de la nano structure 110 est avantageusement mis en œuvre de sorte que l'épaisseur des liaisons 113 à 115 amincies soit comprise entre 2 et 5 nm, typiquement de 3 nm. Une telle épaisseur permet notamment de mettre en œuvre une étape de dépôt par épitaxie sur une partie des liaisons 113 et 114. Une liaison 115 ainsi amincie favorise le couplage par effet tunnel entre les îlots quantiques 111 et 112. L'oxydation de la partie supérieure des liaisons 113 à 115 peut par exemple être mise en œuvre par plasma en chimie H2/O2, ou en chimie HBr/O₂.

L'oxydation de la partie supérieure des liaisons 113 à 115 aboutit simultanément à la formation d'une couche de SiO₂ 119 sur les liaisons 113 à 115 amincies. La formation d'une telle couche de diélectrique 119 durant l'amincissement des liaisons 113 à 115 favorise la qualité de l'interface entre ces liaisons et la couche 119, ce qui limite des perturbations ou les parasites pour les qubits des îlots quantiques 111 et 112.

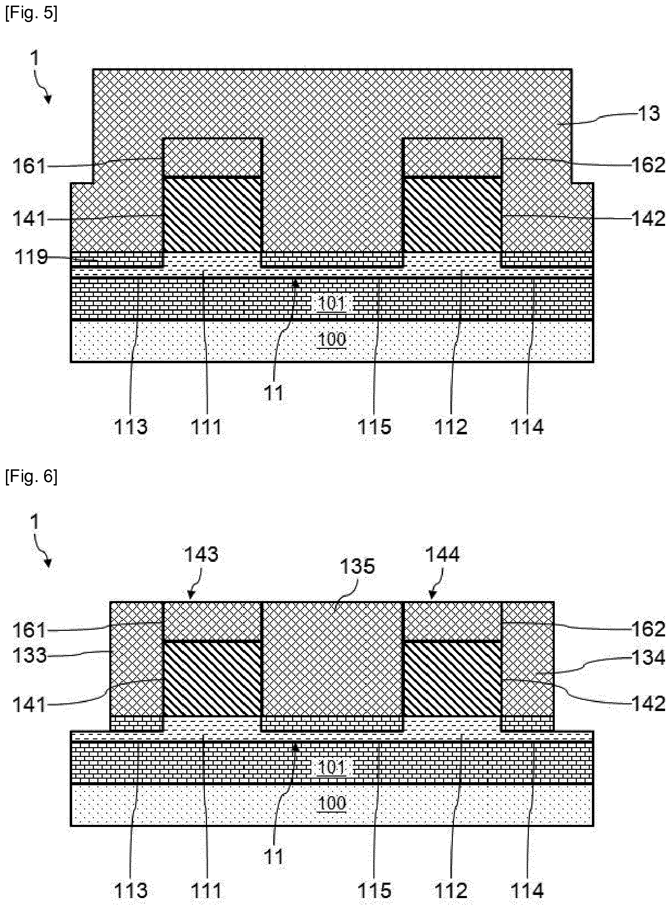

À la figure 5, l'étape 303 est mise en œuvre. On réalise ici un dépôt conforme d'une couche de diélectrique 13, et donc notamment de part et d'autre des empilements de grille 143 et 144. Le diélectrique de la couche 13 est différent de celui de la couche 119. La couche 13 est par exemple réalisée en SiN ou en un matériau présentant une constante diélectrique au plus égale à 6. Le dépôt de la couche 13 est réalisé de façon à remplir la gorge 15 au-dessus de la liaison amincie 115. La couche 13 recouvre alors les empilements de grille 143 et 144. La présence de la couche de diélectrique 13 notamment dans la gorge 15 permet de protéger la liaison 115 durant les étapes technologiques suivantes.

À la figure 6, l'étape 304 est mise en œuvre. Une gravure partielle est mise en œuvre pour conserver une partie de la couche 13 de part et d'autre des empilements de grille 143 et 144 (et notamment dans la gorge 15), et pour découvrir les liaisons 113 et 114 aux extrémités de la nano structure 110 (ou des faces verticales de la nanostructure 110 pour la configuration de la figure 1). La gravure partielle de la couche 13 est par exemple une gravure anisotrope par plasma dans une un réacteur plasma à couplage inductif (ICP). On obtient ainsi un espaceur 135 entre les empilements de grille 143 et 144 et au-dessus de la liaison 115. On obtient également un espaceur 133 au-dessus de la liaison 113, ainsi qu'un espaceur 134 au-dessus de la liaison 114. La gravure partielle permet ainsi de découvrir des extrémités de la nanostructure, tout en conservant une protection de sa partie médiane au moyen de la couche 13 résiduelle.

À la figure 7, l'étape 305 est avantageusement mise en œuvre. Des dépôts de semi-conducteur 151 et 152 sont formés sur des extrémités respectives de la nano structure 110. Les dépôts de semi-conducteur 151 et 152 sont ainsi auto-alignés avec les espaceurs 133 et 134. Les dépôts de semi-conducteur 151 et 152 sont ici formés par épitaxie sur des zones découvertes des liaisons 113 et 114. Les dépôts 151 et 152 forment alors des réservoirs de porteurs aux extrémités de la nano structure 110. Les dépôts 151 et 152 sont en contact par effet tunnel avec les îlots quantiques 111 et 112 respectivement, par l'intermédiaire des liaisons 113 et 114 respectivement. Une étape de polissage mécanochimique ou une étape de gravure sélective peut ensuite être mise en œuvre pour obtenir la configuration illustrée à la figure 1.

Un procédé de fabrication du circuit 1 peut être mis en œuvre selon un deuxième mode de réalisation. Le procédé selon le deuxième mode de réalisation peut être mis en œuvre à partir de la configuration illustrée à la figure 3, après avoir mis en œuvre par exemple les étapes 300 et 301.

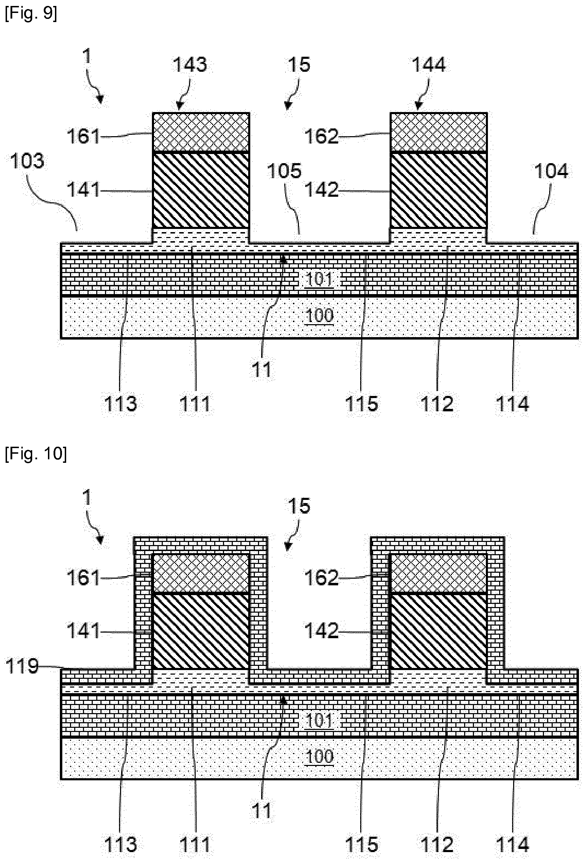

À la figure 9, on met ici en œuvre une étape d'amincissement partiel de la liaison 115. L'amincissement de la liaison 115 est ici mis en œuvre par une gravure. La gravure peut par exemple être réalisée dans les mêmes conditions que dans l'étape 301, en creusant la liaison 115. Les liaisons 113 et 114 sont ici également amincies. Des évidements 103, 104 et 105 sont ainsi formés dans les parties supérieures des liaisons 113, 114 et 115 respectivement. Un amincissement partiel de la nano structure 110 est ainsi mis en œuvre de sorte que les liaisons 113 à 115 sont moins épaisses que les îlots quantiques 111 et 112. L'amincissement partiel de la nano structure 110 est avantageusement mis en œuvre de sorte que l'épaisseur des liaisons 113 à 115 amincies soit comprise entre 2 et 5 nm, typiquement de 3 nm.

À la figure 10, on réalise ici un dépôt conforme d'une couche de diélectrique 119. La couche de diélectrique 119 recouvre la liaison 115. La couche de diélectrique 119 recouvre ici également les liaisons 113 et 114. La couche de diélectrique 119 est par exemple réalisée en SiO₂. La couche de diélectrique 119 est par exemple déposée sur une épaisseur équivalente à la profondeur de l'amincissement partiel réalisé dans la liaison 115.

À la figure 11, on réalise ici un dépôt conforme d'une couche de diélectrique 13. Le diélectrique de la couche 13 est différent de celui de la couche 119. La couche 13 est par exemple réalisée en SiN ou en un matériau présentant une constante diélectrique au plus égale à 6. Le dépôt de la couche 13 est par exemple réalisé de façon à remplir la gorge 15. La couche 13 recouvre la couche 119 et les empilements de grille 143 et 144.

À la figure 12, une gravure est mise en œuvre pour conserver une partie de la couche 13 de part et d'autre des empilements de grille 143 et 144 (et notamment dans la gorge 15), et pour découvrir les liaisons 113 et 114 aux extrémités de la nano structure 110. La gravure est ainsi poursuivie à travers la couche 119 pour découvrir une partie des liaisons 113 et 114 aux extrémités de la nano structure 110. La gravure partielle de la couche 13 est par exemple une gravure anisotrope par plasma dans une chambre à plasma ICP. On obtient ainsi un espaceur 135 entre les empilements de grille 143 et 144 et au-dessus de la liaison 115. On obtient également un espaceur 133 au-dessus de la liaison 113, ainsi qu'un espaceur 134 au-dessus de la liaison 114.

À la figure 13, des dépôts de semi-conducteur 151 et 152 sont formés sur des extrémités respectives de la nano structure 110. Les dépôts de semi-conducteur 151 et 152 sont ici formés par épitaxie sur des zones découvertes des liaisons 113 et 114. Les dépôts 151 et 152 forment alors des réservoirs de porteurs aux extrémités de la nano structure 110. Les dépôts 151 et 152 sont en contact par effet tunnel avec les îlots quantiques 111 et 112 respectivement, par l'intermédiaire des liaisons 113 et 114 respectivement. Une étape de polissage mécanochimique ou une étape de gravure sélective peut ensuite être mise en œuvre pour obtenir la configuration illustrée à la figure 1.

Un procédé de fabrication du circuit 1 peut être mis en œuvre selon un troisième mode de réalisation. Le procédé selon le troisième mode de réalisation peut être mis en œuvre à partir de la configuration illustrée à la figure 9, après avoir mis en œuvre les étapes correspondantes du procédé de fabrication selon le deuxième mode de réalisation.

À la figure 14, on réalise ici un dépôt pleine plaque d'une couche de diélectrique 119. Le dépôt de la couche 119 peut par exemple être mis en œuvre par revêtement par centrifugation. La couche de diélectrique 119 est par exemple réalisée en SiO₂. La couche de diélectrique 119 remplit notamment la gorge 15. Une étape de polissage mécanochimique peut ensuite être mise en œuvre pour obtenir la configuration illustrée à la figure 14.

À la figure 15, une gravure est mise en œuvre pour conserver une partie de la couche 119 de part et d'autre des empilements de grille 143 et 144 (et notamment dans la gorge 15). La gravure est ainsi mise en œuvre pour dégager la gorge 15 mais de sorte que cette couche 119 recouvre encore la liaison 15 d'une part, et les liaisons 113 et 114 d'autre part. Une telle gravure peut par exemple être mise en œuvre avec du HF (avec typiquement un contrôle en temps de gravure) ou un mélange de NH₃ et de NF₃ (avec typiquement un contrôle par cycle). De telles chimies sont notamment sélectives par rapport aux couches formées en SiN ou en Si. Une telle gravure peut par exemple être mise en œuvre pour conserver une épaisseur de couche 119 comprise entre 2 et 5 nm, et typiquement de 3 nm.

Le procédé selon le troisième mode de réalisation peut alors être poursuivi par la mise en œuvre des étapes de procédé décrites en référence aux figures 5 à 7 du premier mode de réalisation.

L'invention a été illustrée avec une nano structure sous forme de nanofil. On peut cependant également envisager d'appliquer l'invention à partir d'une nano structure sous forme de nano couche.

L'invention a été illustrée en référence à un substrat de type Silicium sur Isolant mais on pourrait également l'appliquer à un substrat massif.

L'invention a été illustrée en référence à un exemple incluant deux îlots quantiques couplés. L'invention s'applique également à un circuit présentant davantage d'îlots quantiques.

## Revendications

1. Procédé de fabrication d'un composant électronique (1) à multiples îlots quantiques, comprenant les étapes de :
- fourniture d'un empilement incluant un substrat (100), une nano structure (110) en matériau semi-conducteur superposé sur le substrat (100), la nano structure comportant des premier et deuxième îlots quantiques (111, 112) et une liaison (115) reliant ces premier et deuxième îlots quantiques, des premier et deuxième empilements de grille de commande (143, 144) étant disposés sur lesdits premier et deuxième îlots quantiques (111, 112), lesdits premier et deuxième empilements de grille (143, 144) étant séparés par une gorge (15), les premier et deuxième îlots quantiques et ladite liaison (115) présentant une même épaisseur;
- amincissement partiel de ladite liaison (115) en utilisant les premier et deuxième empilements de grille (143, 144) comme masques, de façon à obtenir une liaison présentant une épaisseur inférieure à celle des premier et deuxième îlots quantiques ;
- formation conforme d'une couche de diélectrique (13) de part et d'autre des premier et deuxième empilements de grille de façon à remplir la gorge au-dessus de ladite liaison amincie (115) ;
- gravure partielle de la couche de diélectrique pour conserver une partie de la couche de diélectrique (133, 134, 135) de part et d'autre des premier et deuxième empilements de grille et dans la gorge (15), et pour découvrir des première et deuxième extrémités de la nanostructure (110) ;- formation de premier et deuxième réservoirs de porteurs (151, 152) de part et d'autre de la partie conservée de la couche de diélectrique, en contact avec les première et deuxième extrémités de la nanostructure (110).

2. Procédé de fabrication selon la revendication 1, dans lequel ledit empilement fourni comprend une couche de diélectrique enterrée (101) interposée entre le substrat (100) et la nano structure (110).

3. Procédé de fabrication selon la revendication 1 ou 2, dans lequel ladite nano structure (110) de l'empilement fourni est une nano couche ou un nanofil.

4. Procédé de fabrication selon la revendication 1 ou 2, dans lequel ladite nano structure (110) est en matériau semi conducteur non intentionnellement dopé.

5. Procédé de fabrication selon l'une quelconque des revendications précédentes, dans lequel ladite étape d'amincissement comprend une étape de formation d'une couche de diélectrique (119) sur ladite liaison par oxydation d'une partie supérieure de ladite liaison (115).

6. Procédé de fabrication selon l'une quelconque des revendications 1 à 4, dans lequel ladite étape d'amincissement partiel inclut une gravure.

7. Procédé de fabrication selon la revendication 6, dans lequel ladite étape d'amincissement partiel de la liaison (115) inclut une gravure de type anisotrope.

8. Procédé de fabrication selon l'une quelconque des revendications précédentes, dans lequel le premier réservoir de porteurs (151) formé est en contact par effet tunnel par l'intermédiaire d'une autre liaison (113) avec le premier îlot quantique (111).

9. Procédé de fabrication selon la revendication 8, dans lequel ladite étape de formation du premier réservoir de porteurs (151) comprend un dépôt par épitaxie de matériau semi-conducteur sur ladite extrémité de la nano structure (110).

10. Procédé de fabrication selon la revendication 8 ou 9, dans lequel ledit creusement partiel de ladite liaison (115) comprend l'amincissement partiel de ladite autre liaison (113), de sorte que lesdites liaisons (114, 113) présentent une même épaisseur.

11. Procédé de fabrication selon l'une quelconque des revendications précédentes, dans lequel ladite gorge (15) entre les premier et deuxième îlots quantiques fournis présente une largeur comprise entre 20 et 120 nanomètres.

12. Procédé de fabrication selon l'une quelconque des revendications précédentes, dans lequel ladite liaison amincie (115) présente une épaisseur comprise entre 2 et 10 nm.

13. Procédé de fabrication selon l'une quelconque des revendications précédentes, dans lequel ledit amincissement est réalisé de façon à maintenir les premiers et deuxième îlots quantiques alignés avec la verticale des premier et deuxième empilements de grille de commande (143, 144);

14. Composant électronique (1) à multiples îlots quantiques, comprenant :
- un substrat (100) ;
- une nano structure (110) en matériau semi-conducteur superposé sur le substrat (100) et comportant des premier et deuxième îlots quantiques (111, 112) et une liaison (115) reliant ces premier et deuxième îlots quantiques ;
- des premier et deuxième empilements de grille de commande (143, 144) disposés sur lesdits premier et deuxième îlots quantiques (111, 112) et séparés par une gorge (15), la liaison présentant une épaisseur inférieure à celle des premier et deuxième îlots quantiques; les premier et deuxième ilots quantiques étant alignés avec la verticale des premier et deuxième empilements de grille de commande (143, 144) ;
- une couche de diélectrique (133, 134, 135) disposée de part et d'autre des premier et deuxième empilements de grille et remplissant la gorge (15);
- des premier et deuxième réservoirs de porteurs (151, 152) de part et d'autre de la couche de diélectrique, en contact avec des première et deuxième extrémités de la nanostructure (110).

15. Composant électronique (1) à multiples îlots quantiques selon la revendication 14, dans lequel la couche de diélectrique ne recouvre pas des première et deuxième extrémités de la nanostructure (110), les premier et deuxième réservoirs de porteurs (151, 152) étant positionnés au-dessus des première et deuxième extrémités de la nanostructure (110).

16. Composant électronique (1) à multiples îlots quantiques selon la revendication 14 ou 15, dans lequel la couche de diélectrique remplissant la gorge est obtenue par dépôt conforme de matériau diélectrique. 1
